# EUROPÄISCHE PATENTSCHRIFT

(11) **EP 2 087 779 B1**
(45) Veröffentlichungstag und Bekanntmachung des Hinweises auf die Patenterteilung: **20.06.2018**
(21) Anmeldenummer: 07817671.6
(22) Anmeldetag: 16.10.2007
(51) Int. Cl.: H05K 1/18, H05K 5/00, B60R 16/023

(54) **KOMPAKTES STEUERGERÄT FÜR EIN KRAFTFAHRZEUG**
COMPACT CONTROL UNIT FOR A MOTOR VEHICLE
APPAREIL DE COMMANDE COMPACT POUR VÉHICULE AUTOMOBILE

(30) Priorität: 20.10.2006 DE 102006049593
(43) Veröffentlichungstag der Anmeldung: 12.08.2009
(73) Patentinhaber: Conti Temic Microelectronic GmbH, 90411 Nürnberg (DE)
(72) Erfinder: EGLINGER, Markus, 48188 Canton, MI (US); BUHL, Joachim, 90482 Nürnberg (DE); GRAMANN, Matthias, 77871 Renchen (DE); FÜLLER, Steffen, 19061 Schwerin (DE)
(74) Vertreter: Bonn, Roman Klemens
(86) Internationale Anmeldenummer: PCT/DE2007/001836
(87) Internationale Veröffentlichungsnummer: WO 2008/046400

(56) Entgegenhaltungen:
- DE-A1- 4 228 818
- DE-A1- 10 340 974
- DE-A1- 19 907 949
- DE-C1- 4 023 319
- DE-C1- 19 712 842
- DE-U1- 29 508 661

## Beschreibung

Die Erfindung betrifft ein Steuergerät für ein Kraftfahrzeug nach dem Oberbegriff des Anspruchs 1 sowie ein Verfahren zu dessen Herstellung nach Anspruch 9 oder 10.

Im Kraftfahrzeugbau ist es seit längerer Zeit üblich, Steuergeräte für Motor oder Getriebe in die zu steuernde Kraftfahrzeugbaugruppe, also Motor oder Getriebe, zu integrieren. Vor allem die Getriebesteuergeräte bilden als Vorortsteuergerät eine äußerst kompakte Einheit. Im Vergleich zur konventionellen Verwendung externer Steuergeräte hat diese Anordnung enorme Vorteile im Bezug auf Kosten, Gewicht, Funktionalität und Qualität. Insbesondere resultiert daraus eine erhebliche Verringerung an Steckverbindungen und Leitungen.

Die Integration des Steuergerätes in das Getriebe stellt hohe Anforderungen an seine thermische und mechanische Belastbarkeit. Die Funktionalität muss sowohl über einen breiten Temperaturbereich (etwa -40°C bis 150°C) als auch bei starken mechanischen Vibrationen (bis zu etwa 40g) gewährleistet sein. Da das Steuergerät von Getriebeöl umgeben ist, muss es zudem öldicht ausgeführt sein.

Ein derartiges Steuergerät ist aus der DE 199 07 949 A1 bekannt. Ein Gehäusedeckel und eine Bodenplatte, auf der ein flächiger flexibler Folienleiter aufgebracht ist, umschließen einen Hohlraum. In diesem Hohlraum ist auf der Bodenplatte eine elektronische Schaltung so angeordnet, dass sie allseitig von der flexiblen Leiterplatte umgeben ist. Dabei sind Leiterbahnen der flexiblen Leiterpatte über Bonddrähte mit entsprechenden Kontaktpads auf dem Schaltungsträger verbunden. Der Gehäusedeckel ist über eine umlaufende Ringdichtung öldicht auf die Bodenplatte montiert. Die flexible Leiterplatte ist zwischen der Ringdichtung und der Bodenplatte aus dem Hohlraum des Steuergerätegehäuses heraus geführt. Die flexible Leiterplatte stellt die Verbindung zwischen der elektronischen Schaltung im Hohlraum des Steuergerätegehäuses zu Elektrobauteilen wie Sensoren oder Aktoren außerhalb des Hohlraums her.

Die flexible Leiterpatte ist aus einem Stück. Bei komplexen Anordnungen des Steuergerätes und der umgebenden Bauteile führt dies, rechnet man nur die Aussparung für die elektronische Schaltung in der Mitte der flexiblen Leiterpatte, zu einem großen Verschnitt und ist deshalb unwirtschaftlich.

Darüber hinaus ist mit der Form der flexiblen Leiterplatte die Position der Elektrobauteile außerhalb des Hohlraums festgelegt und erfordert bei der Änderung der Lage nur eines Bauteiles die Änderung der Form der gesamten flexiblen Leiterpatte.

DE 103 40 974 A1 offenbart ein Steuergerät gemäß dem Oberbegriff des Anspruchs 1 und ein Verfahren zur Herstellung desselben.

Der Erfindung liegt die Aufgabe zu Grunde, ein Steuergerät für ein Kraftfahrzeug zu schaffen, das eine wirtschaftliche und mechanisch sichere elektrische Verbindung der Steuerelektronik des Steuergerätes mit externen elektronischen Bauteilen in einer kompakten Bauweise ermöglicht.

Diese Aufgabe wird erfindungsgemäß gelöst durch ein Steuergerät mit den Merkmalen des Anspruchs 1.

Zweckmäßigerweise sind die Folienleiter als separate Folienleiterstreifen ausgeführt. Dadurch wird Folienleitermaterial gespart und bei Änderungen der Position eines elektronischen Bauteils außerhalb des den Schaltungsträger umlaufend umgebenen Rahmens kann die Position des entsprechenden Folienleiters unter Beibehaltung der Position der übrigen Folienleiter schnell angepasst werden.

Die Folienleiterstreifen weisen an ihren dem Schaltungsträger zugewandten Endabschnitten jeweils einen elektrischen Kontaktbereich auf, wobei alle Endabschnitte außerhalb der den Schaltungsträger umlaufend umgebenden Dichtung des Rahmens angeordnet sind. Dadurch wird gewährleistet, dass die im Rahmen umlaufende, den Schaltungsträger umgebende Dichtung ausschließlich zwischen Bodenplatte und Rahmen verläuft. Der Rahmen weist im Bereich des elektrischen Kontaktbereiches eines Folienleiterstreifens einen Durchbruch auf. Durch diesen Durchbruch sind die elektrischen Verbindungsleitungen, insbesondere Bonddrähte, zwischen den Bauteilen und/oder den Kontaktbereichen auf dem Schaltungsträger und dem elektrischen Kontaktbereich des Folienleiterstreifens angebracht. Der Rahmen ist im Bereich des Durchbruchs mittels einer den Durchbruch umlaufenden und den elektrischen Kontaktbereich des Folienleiterstreifens umgebenden Dichtung öldicht mit der Bodenplatte gekoppelt, wobei die den Durchbruch umlaufende Dichtung vorzugsweise innerhalb des Folienleiterstreifens angeordnet ist.

Die Bodenplatte muss zur Gewährleistung einer den Anforderungen entsprechenden mechanischen Festigkeit ein gewisse Dicke aufweisen. Vorteilhafterweise sind auf der Bodenplatte zusätzliche Komponenten, wie zum Beispiel Stecker, Sensoren oder Aktoren angeordnet. Um eine möglichst geringe Bauhöhe des Steuergerätes zu erreichen, ist der den Schaltungsträger umgebende Rahmen in einer Vertiefung in der Bodenplatte untergebracht.

Vorzugsweise ist die im Rahmen umlaufende Dichtung und die einen Durchbruch umlaufende Dichtung aus einem Stück gefertigt. Dadurch wird im Falle, dass die Dichtung als Einlegeteil ausgeführt ist, die Positionierung des Dichtelements durch den Wegfall mindestens eines Arbeitschrittes erleichtert. Die jeweiligen Dichtflächen der Dichtungen sind im Bereich von Durchbrüchen, in dem sie aneinander angrenzend nahezu parallel verlaufen, durch eine Nut getrennt. Dadurch sind die Dichtbereiche der Durchbrüche vom Dichtbereich des Schaltungsträgers wie im Falle von Einzeldichtungen separiert.

In einer weiteren Ausführungsform des Steuergerätes sind Deckel und Rahmen als ein einstückiges Gehäuse ausgeführt. Dabei weist das Gehäuse im Deckel jeweils in dem Bereich, der ein elektronisches Bauteil und/oder einen Kontaktbereich des Schaltungsträgers und einen elektrischen Kontaktbereich des entsprechenden Endabschnitts des Folienleiterstreifens umfasst, eine Aussparung auf. Durch diese Aussparung ist eine elektrische Verbindung zwischen dem elektronischen Bauteil und/oder den Kontaktbereich des Schaltungsträgers und dem elektrischen Kontaktbereich des entsprechenden Endabschnitts des Folienleiterstreifens mittels der elektrischen Verbindungsleitungen herstellbar. Die Aussparung ist anschließend mit einem Deckelteil mittels Laserschweißung oder Klebung oder Verstemmung öldicht verschließbar.

Für den Fall, dass das Steuergerät in einem Getriebe eingesetzt wird, wird vorteilhafterweise dadurch Bauraum eingespart, dass die Bodenplatte des Steuergerätes ein Teil der Getriebehydraulikeinheit ist, zum Beispiel die Ventilplatte.

Eine weitere Aufgabe der Erfindung ist es, ein Verfahren zur Herstellung eines Steuergerät für ein Kraftfahrzeug nach Anspruch 1 zu schaffen.

Diese Aufgabe wird erfindungsgemäß gelöst durch ein Verfahren mit den Merkmalen des Anspruchs 9.

Zunächst wird ein Schaltungsträger, zum Beispiel mittels eines Klebers, direkt auf eine Bodenplatte aufgebracht. Die Bodenplatte wirkt dadurch besonders gut als Wärmesenke für die elektronischen Bauelemente auf dem Schaltungsträger. Insbesondere sind auf dem Schaltungsträger auch zusätzliche Kontaktbereiche angeordnet, die über Leiterbahnen mit elektronischen Bauelementen, die nicht im Randbereich des Schaltungsträgers angeordnet sind, elektrisch verbunden sind.

Anschließend werden mehrere im wesentlichen streifenförmiger Folienleiter auf der Bodenplatte beabstandet um den Schaltungsträger positioniert und fixiert. Die Folienleiterstreifen weisen an ihren dem Schaltungsträger zugewandten Endabschnitten jeweils einen elektrischen Kontaktbereich auf. Die Position eines Folienleiterstreifens wird derart gewählt, dass der mit einem elektrischen Kontaktbereich versehene Endabschnitt im Bereich mindestens eines elektronischen Bauteils und/oder elektrischen Kontaktbereichs des Schaltungsträgers angeordnet wird. Das Fixieren der Folienleiterstreifen geschieht vorzugsweise durch Kaltlaminieren oder kleben

Im nächsten Schritt wird ein Rahmen so auf der Bodenplatte angeordnet, dass er den Schaltungsträger umlaufend umgibt und dass ein Durchbruch im Rahmen über dem entsprechenden elektrischen Kontaktbereich eines Endabschnitts eines Folienleiterstreifens derart positioniert wird, dass die im Durchbruch des Rahmens umlaufende Dichtung den elektrischen Kontaktbereich vollständig umgibt. Dabei ist darauf zu achten, dass die Dichtung nur auf dem Folienleiterstreifen verläuft, da ein Übergang von Folienleiterstreifen zur Bodenplatte schwerlich gegen Öl abzudichten ist. Eine zwischen den Endabschnitten der Folienleiterstreifen und dem Schaltungsträger, den Schaltungsträger umlaufend umgebende Dichtung zwischen Bodenplatte und Rahmen gewährleistet nach der Montage des Rahmens auf der Bodenplatte die Öldichtheit des Steuergerätes in diesem Bereich. Die Montage des Rahmens auf der Bodenplatte kann durch Verschrauben, Vernieten , Verkleben oder durch eine andere dem Fachmann bekannte Technik geschehen.

Danach werden die elektronischen Bauteile und/oder die elektrischen Kontaktbereiche auf
dem Schaltungsträger mittels elektrischer Verbindungsleitungen mit den entsprechenden elektrischen Kontaktbereichen auf den Endabschnitten der Folienleiterstreifen durch die jeweiligen Durchbrüche im Rahmen elektrisch verbunden. Bevorzugt wird hierbei das Anbringen von Bonddrähten.

Abschließend wird ein Deckel auf dem Rahmen montiert. Die Öldichtheit wird durch eine im Deckel oder im Rahmen umlaufende Dichtung gewährleistet. Die Montage des Deckels auf dem Rahmen kann durch Verschrauben, Vernieten , Verkleben oder durch eine andere dem Fachmann bekannte Technik geschehen.

Eine weitere Aufgabe der Erfindung ist es, ein Verfahren zur Herstellung eines Steuergerät für ein Kraftfahrzeug nach Anspruch 5 zu schaffen.

Diese Aufgabe wird erfindungsgemäß gelöst durch ein Verfahren mit den Merkmalen des Anspruchs 10, wobei der Gehäusedeckel und der Rahmen als einstückig ausgeführt sind.

Das Aufbringen des Schaltungsträgers und der Folienleiterstreifen geschieht analog dem vorher beschriebenen Verfahren. Anschließend wird der Gehäusedeckel entsprechend dem Rahmen im vorherigen Verfahren auf der Bodenplatte montiert. Die den Schaltungsträger umlaufende Dichtung und die die elektrischen Kontaktbereiche auf den Endabschnitten der Folienleiterstreifen umlaufenden Dichtungen sind in diesem Fall in einem im Deckelinneren verlaufenden Rand untergebracht.

Im nächsten Schritt werden die elektronischen Bauteile und/oder die elektrischen Kontaktbereiche auf dem Schaltungsträger mit den entsprechenden elektrischen Kontaktbereichen auf den Endabschnitten der Folienleiterstreifen durch jeweilige Aussparungen im Gehäusedeckel elektrisch verbunden. Bevorzugt wird hierbei ebenfalls das Anbringen von Bonddrähten.

Abschließend werden die Aussparungen durch entsprechende Deckelteile mittels Laserschweißen, Kleben oder eine andere bekannte Technik öldicht verschlossen.

Weiter Merkmale, Vorteile und Einzelheiten sind der nachfolgenden Beschreibung entnehmbar, in der bevorzugte Ausführungsbeispiele näher erläutert werden. Es zeigen:
Fig. 1 einen Schnitt durch ein Steuergerät mit Rahmen und separatem Gehäusedeckel,
Fig. 2 einen Schnitt durch ein Steuergerät mit Rahmen und Gehäusedeckel aus einem Stück,
Fig. 3 eine Draufsicht auf Fig. 1 oder Fig. 2 in der jeweiligen Ebene A-A und
Fig. 4 einen Schnitt durch eine einstückige Dichtung im Bereich eines Durchbruchs.

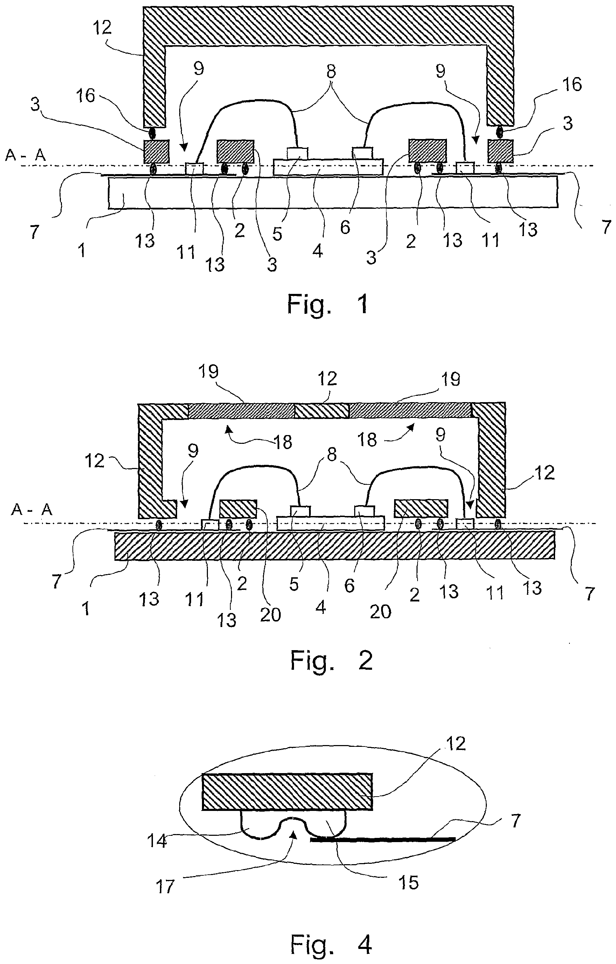

Fig. 1 zeigt ein Steuergerät, bei dem ein Schaltungsträger 4 direkt auf einer Bodenplatte 1 angeordnet ist. Die Verbindung kann durch Laminieren, insbesondere Kaltlaminieren, oder durch Kleben, vorzugsweise mit einem elektrisch isolierenden Wärmeleitkleber hergestellt sein. Die Bodenplatte 1 ist insbesondere aus Metall und dient dann gleichzeitig als Wärmesenke für die auf dem Schaltungsträger 4 erzeugte Wärme. Auf dem Schaltungsträger 4, vorzugsweise in dessen Randbereich, ist mindestens ein elektronisches Bauteil 5 der Steuerelektronik angeordnet. Bauteile, die eher im inneren Bereich es Schaltungsträgers 4 angeordnet sind, sind insbesondere über hier nicht gezeigte Leiterbahnen des Schaltungsträgers 4 mit elektrischen Kontaktbereichen 6 im Randbereich des Schaltungsträgers 4 elektrisch verbunden.

Auf der Bodenplatte 1 sind um den Schaltungsträger 4 flexible Folienleiterstreifen 7, vom Schaltungsträger 4 wegführend, angeordnet. Der sich auf den, dem Schaltungsträger 4 zugewandte Endabschnitt 10 eines Folienleiterstreifens 7 angeordnete elektrische Kontaktbereich 11 befindet sich dabei jeweils gegenüber einem Bauteil 5 und/oder einem Kontaktbereich 6 des Schaltungsträgers 4. Die Folienleiterstreifen 7 sind auf die Bodenplatte 1 vorzugsweise auflaminiert oder aufgeklebt.

Der Schaltungsträger 4 ist allseitig von einem Rahmen 3 umgeben. Der Rahmen ist vorzugsweise aus Kunststoff und ist mit der Bodenplatte 1 beispielsweise durch Schrauben oder Vernieten kraftschlüssig verbunden. Im inneren Umfangsbereich des Rahmens 3 verläuft zwischen dem Schaltungsträger 4 und den Endabschnitten 10 der Folienleiterstreifen 7 eine den Schaltungsträger 4 umgebende Dichtung 2, die in diesem Bereich den Rahmen 3 öldicht an die Bodenplatte 1 koppelt.

Der äußere Umfangsbereich des Rahmens 3 weist jeweils im Bereich eines elektrischen Kontaktbereichs 11 eines Folienleiterstreifens 7 einen Durchbruch 9 auf. Der Kontaktbereich 11 liegt dabei frei im Durchbruch 9. Eine den Durchbruch 9 umlaufende Dichtung 13 koppelt in diesem Bereich den Rahmen 3 öldicht mit dem Folienleiterstreifen 7 auf der Bodenplatte 1. Vorzugsweise verläuft die Dichtung 13 um den Durchbruch 9 gänzlich auf dem Folienleiterstreifen 7, da ein Übergang von dem Folienleiterstreifen 7 auf die Bodenplatte 1 ein Dichtigkeitsrisiko bedeuten könnte.

Die elektrischen Verbindungsleitungen 8 verlaufen von den elektronischen Bauteilen 5 und den elektrischen Kontaktbereichen 6 auf dem Schaltungsträger 4 durch die Durchbrüche 9 zu den Kontaktbereichen 11 auf den Folienleiterstreifen 7. Dadurch wird die Elektronik innerhalb des Rahmens 3 mit elektronischen Bauteilen wie Aktoren, Sensoren oder Steckern außerhalb des Rahmens 3 elektrisch verbunden. Die elektrischen Verbindungsleitungen 8 sind in der Regel durch Bonddrähte realisiert. Der Gehäusedeckel 12 ist über die Ringdichtung 16 beispielsweise mittels Schrauben mit dem Rahmen 3 öldicht verbunden.

Fig. 2 zeigt ein Steuergerät wie in Fig. 1, jedoch mit dem Unterschied, dass der Rahmen 3 aus Fig. 1 im Gehäusedeckel 12 integriert ist und nunmehr einen den Schaltungsträger 4 umlaufend umgebenden Rand 20 des Gehäusedeckels 12 bildet. Dadurch entfällt die in Fig. 1 zwischen dem Gehäusedeckel 12 und dem Rahmen 3 angeordnete Dichtung 16.

Die in der Regel als Bonddrähte ausgeführten elektrischen Verbindungsleitungen 8 zwischen den elektronischen Bauteilen 5 und/oder den elektrischen Kontaktbereichen 6 auf dem Schaltungsträger 4 und den Kontaktbereichen 11 auf den Folienleitern 7 sind durch Aussparungen 18 im Gehäusedeckel 12 eingebracht. Die Aussparungen 18 sind durch die Deckelteile 12 insbesondere mittels Laserschweißen, Kleben oder Verstemmen öldicht verschließbar.

In einer besonderen Ausführungsform können die den Schaltungsträger 4 und die Durchbrüche 9 umlaufenden Dichtungen 2, 13 aus einem Stück ausgeführt sein. Im Falle von eingelegten Dichtungen 2, 13 wird dadurch die Montage deutlich vereinfacht. Dabei ist aus Sicherheitsgründen darauf zu achten, dass der Dichtbereich um den Schaltungsträger 4 vom Dichtbereich um die Durchbrüche 9 getrennt ist. Wie in Fig. 4 gezeigt sind die Dichtflächen 14, 15 der Dichtungen 2, 13 im Bereich eines Durchbruchs 9, in dem sie einander angrenzend weitgehend parallel verlaufen, durch eine Nut 17 getrennt. Bei der Anbringung des Rahmens 3 aus Fig. 1 bzw. des Randes 20 aus Fig. 2 ist dann darauf zu achten, dass die Dichtfläche 15 der Dichtung 13 auf dem Endabschnitt 10 des Folienleiters 7 und die Nut 17 zwischen dem Schaltungsträger 4 und dem Endabschnitt 10 zu liegen kommt.

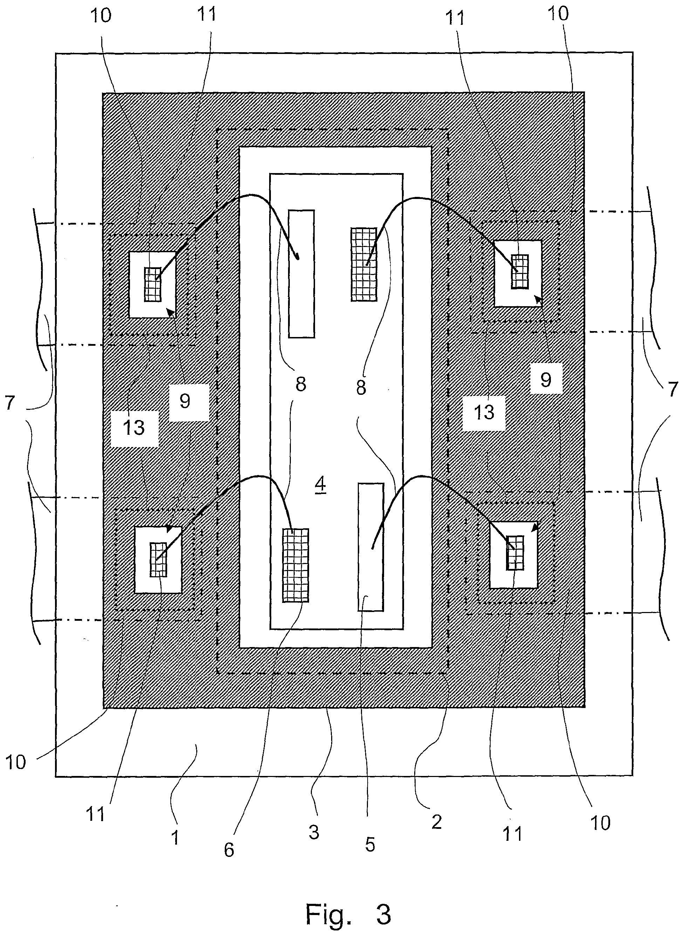

Fig. 3 zeigt eine Draufsicht auf Fig. 1 bzw. Fig. 2 jeweils in der Ebene A-A. Darin wird die Lage des Schaltungsträgers 4, des Rahmens 3 bzw. des Randes 20, der Dichtungen 2, 13, der Folienstreifen 7 und der Durchbrüche 9 noch einmal veranschaulicht. Unter anderem wird im Bereich eines Durchbruchs 9 gezeigt, wie insbesondere der Endabschnitt 10 des Folienleiters 7 den Durchbruch 9 vollständig überdeckt und wie die den Durchbruch 9 umlaufende Dichtung 13 aus Dichtigkeitsgründen vollständig innerhalb des Folienleiters 7 angeordnet.

Für den Fall, dass das Steuergerät in einem Getriebe eingesetzt wird, kann Bauraum eingespart werden, wenn die Bodenplatte 1 des Steuergerätes ein Teil der Getriebehydraulikeinheit ist, zum Beispiel die Ventilplatte. In einer alternativen Ausführungsform des Steuergerätes kann der Gehäusedeckel 12 der Einfachheit halber als flaches Teil ausgeführt sein und die Bodenplatte 1 zur Aufnahme des Schaltungsträgers 4 und des Rahmens 3 eine entsprechende Vertiefung aufweisen.

### Bezugszeichenliste:

- 1.: Bodenplatte
- 2.: Dichtung um Schaltungsträger 4
- 3.: Rahmen
- 4.: Schaltungsträger
- 5.: Elektronisches Bauteil auf dem Schaltungsträger
- 6.: Elektrischer Kontaktbereich auf dem Schaltungsträger
- 7.: Folienleiter
- 8.: Elektrische Verbindungsleitung
- 9.: Durchbruch im Rahmen bzw. im Gehäusedeckel 12
- 10.: Endabschnitt des Folieneiters zum Schaltungsträger hin
- 11.: Elektrischer Kontaktbereich auf dem Endabschnitt des Folienleiters
- 12.: Gehäusedeckel
- 13.: Dichtung, den Durchbruch umlaufend
- 14.: Dichtfläche der Dichtung 2
- 15.: Dichtfläche der Dichtung 13
- 16.: Dichtung zwischen Gehäusedeckel und Bodenplatte
- 17.: Nut zwischen Dichtfläche 14 und Dichtfläche 15
- 18.: Aussparung in Gehäusedeckel
- 19.: Deckelteil
- 20.: Rand des Gehäusedeckels

## Patentansprüche

1. Steuergerät für ein Kraftfahrzeug, das umfasst:
a) eine Bodenplatte (1),
b) einen Schaltungsträger (4), der auf der Bodenplatte (1) angeordnet ist, und der mindestens ein elektronisches Bauteil (5) und/oder mindestens einen elektrischen Kontaktbereich (6) umfasst,
c) einen den Schaltungsträger (4) umlaufend umgebenden Rahmen (3), der mittels einer den Schaltungsträger (4) umlaufend umgebenden Dichtung öldicht (2) mit der Bodenplatte (1) gekoppelt ist,
d) mindestens einen auf der Bodenplatte (1) verlaufenden Folienleiter (7) zum elektrischen Verbinden von elektronischen Bauteilen innerhalb des Rahmens (3) mit elektronischen Bauteilen außerhalb des Rahmens (3), und
e) elektrische Verbindungsleitungen (8) zwischen den Bauteilen (5) und/oder den Kontaktbereichen (6) auf dem Schaltungsträger (4) und dem Folienleiter (7),
f) einen Gehäusedeckel (12), der öldicht mit dem Rahmen (3) gekoppelt ist,
**dadurch gekennzeichnet, dass**
g) die Folienleiter (7) als mehrere separate Folienleiterstreifen ausgeführt sind, die an ihren dem Schaltungsträger (4) zugewandten Endabschnitten (10) jeweils einen elektrischen Kontaktbereich (11) aufweisen, wobei die Endabschnitte (10) außerhalb der den Schaltungsträger (4) umlaufend umgebenden Dichtung (2) angeordnet sind,
h) der Rahmen (3) im Bereich des elektrischen Kontaktbereiches (11) eines Folienleiterstreifens (7) einen Durchbruch (9) zum Durchführen der elektrischer Verbindungsleitungen (8) von den Bauteilen (5) und/oder den Kontaktbereichen (6) auf dem Schaltungsträger (4) zum elektrischen Kontaktbereich (11) des Folienleiterstreifens (7) aufweist, und
i) der Rahmen (3) eine den Durchbruch (9) umlaufende, den elektrischen Kontaktbereich (11) des Folienleiterstreifens (7) umgebende Dichtung (13) aufweist, mittels der der Rahmen (3) im Bereich des Durchbruchs (9) öldicht mit dem folienleiterstreifen auf der Bodenplatte (1) gekoppelt ist.

2. Steuergerät nach Anspruch 1, **dadurch gekennzeichnet, dass** die den Durchbruch (9) umlaufende Dichtung (13) vollständig innerhalb des Folienleiterstreifens (7) angeordnet ist.

3. Steuergerät nach Anspruch 1 oder 2, **dadurch gekennzeichnet, dass** die Bodenplatte (1) eine Vertiefung zur Aufnahme des Rahmens (3) aufweist.

4. Steuergerät nach einem der vorhergehenden Ansprüche, **dadurch gekennzeichnet, dass** die den Schaltungsträger (4) umlaufende Dichtung (2) und die einen Durchbruch (9) umlaufende Dichtung (13) aus einem Stück sind, wobei die jeweiligen Dichtflächen (14, 15) in dem Bereich von Durchbrüchen (9) , in dem sie angrenzend nahezu parallel verlaufen, durch eine Nut (17) getrennt sind.

5. Steuergerät nach einem der vorhergehenden Ansprüche, **dadurch gekennzeichnet, dass** der Rahmen (3) am Gehäusedeckel (12) integriert ist.

6. Steuergerät nach Anspruch 5, **dadurch gekennzeichnet, dass** der Gehäusedeckel (12) jeweils in dem Bereich, der ein elektronisches Bauteil (5) und/oder einen elektrischen Kontaktbereich (6) auf dem Schaltungsträger (4) und einen elektrischen Kontaktbereich (11) des entsprechenden Endabschnitts(10) des Folienleiterstreifens (7) umfasst, eine Aussparung (18) aufweist, durch die eine elektrische Verbindung zwischen dem elektronischen Bauteil (5) und/oder dem Kontaktbereich (6) des Schaltungsträgers (4) und dem elektrischen Kontaktbereich (11) des entsprechenden Endabschnitts(10) des Folienleiterstreifens (7) mittels der elektrischen Verbindungsleitungen (8) herstellbar ist, wobei die Aussparung (18) mit einem Deckelteil (19) öldicht verschließbar ist.

7. Steuergerät nach Anspruch 6, **dadurch gekennzeichnet, dass** die Aussparung (18) mit dem Deckelteil (19) mittels Laserschweißung oder Klebung oder Verstemmung öldicht verschlossen ist.

8. Steuergerät nach einem der vorhergehenden Ansprüche, **dadurch gekennzeichnet, dass** die Bodenplatte (1) ein Teil einer Getriebehydraulikeinheit ist.

9. Verfahren zur Herstellung eines Steuergerätes für ein Kraftfahrzeug nach Anspruch 1, **gekennzeichnet durch** die Schritte:
a) Bereitstellen einer Bodenplatte (1),
b) Aufbringen eines Schaltungsträgers (4) auf der Bodenplatte (1),wobei der Schaltungsträger (4) mindestens ein elektronisches Bauteil (5) und/oder mindestens einen elektrischen Kontaktbereich (6) umfasst,
c) Positionieren und Fixieren mehrerer im wesentlichen streifenförmiger Folienleiter (7) auf der Bodenplatte (1) derart, dass die dem Schaltungsträger (4) zugewandten, mit einem elektrischen Kontaktbereich (11) versehenen Endabschnitte (10) der Folienleiterstreifen (7) im Bereich mindestens eines elektronischen Bauteils (5) und/oder elektrischen Kontaktbereichs (6) des Schaltungsträgers (4) fixiert werden,
d) Montage eines den Schaltungsträger (4) umlaufend umgebenden Rahmens (3) derart, dass ein Durchbruch (9) des Rahmens (3) über dem elektrischen Kontaktbereich (11) am Endabschnitt (10) eines Folienleiterstreifens (7) angeordnet wird, wobei der Rahmen (3)
- im unmittelbaren Bereich des Schaltungsträgers (4) mittels einer den Schaltungsträger (4) umlaufenden, zwischen dem Schaltungsträger (4) und den Endabschnitten (10) der Folienleiter (7) verlaufenden Dichtung (2), und
- im Bereich des Durchbruchs (9) mittels einer den Durchbruch (9) umlaufenden, den elektrischen Kontaktbereich (11) eines Folienleiterstreifens (7) umgebenden und innerhalb des Folienleiters (7) angeordneten Dichtung (13) öldicht mit der Bodenplatte (1) gekoppelt wird,
e) Anbringen von elektrischen Verbindungsleitungen (8) zwischen den elektronischen Bauteilen (5) und/oder den elektrischen Kontaktbereichen (6) auf dem Schaltungsträger (4) und dem elektrischen Kontaktbereich des Folienleiterstreifens (11) durch den entsprechenden Durchbruch (9) hindurch, und
f) Montage eines über eine Dichtung (16) öldicht mit dem Rahmen (3) koppelbaren Gehäusedeckels (12).

10. Verfahren zur Herstellung eines Steuergerätes für ein Kraftfahrzeug nach Anspruch 5, **gekennzeichnet durch** die Schritte:
a) Bereitstellen einer Bodenplatte (1),
b) Aufbringen eines Schaltungsträgers (4) auf der Bodenplatte (1), wobei der Schaltungsträger (4) mindestens ein elektronisches Bauteil (5) und/oder mindestens einen elektrischen Kontaktbereich (6) umfasst,
c) Positionieren und Fixieren mehrerer im wesentlichen streifenförmiger Folienleiter (7) auf der Bodenplatte (1) derart, dass die dem Schaltungsträger (4) zugewandten, mit einem elektrischen Kontaktbereich (11) versehenen Endabschnitte (10) der Folienleiterstreifen (7) im Bereich mindestens eines elektronischen Bauteils (5) und/oder elektrischen Kontaktbereichs (6) des Schaltungsträgers (4) fixiert werden,
d) Montage eines im wesentlichen haubenförmigen Gehäusedeckels (12) mit einem im Deckelinneren verlaufenden und den Schaltungsträger (4) umlaufend umgebenden Rand (20) derart, dass ein Durchbruch (9) des Randes (20) über einem elektrischen Kontaktbereich (11) am Endabschnitt (10) eines Folienleiterstreifens (7) angeordnet wird, wobei der Rand (20)
- im unmittelbaren Bereich des Schaltungsträgers (4) mittels einer den Schaltungsträger (4) umlaufenden, zwischen dem Schaltungsträger (4) und den Endabschnitten (10) der Folienleiter (7) verlaufenden Dichtung (2), und
- im Bereich des Durchbruchs (9) mittels einer den Durchbruch (9) umlaufenden, den elektrischen Kontaktbereich (11) eines Folienleiters (7) umgebenden und innerhalb des Folienleiters (7) angeordneten Dichtung (13) öldicht mit der Bodenplatte (1) gekoppelt wird,
e) Anbringen von elektrischen Verbindungsleitungen (8) zwischen den elektronischen Bauteilen (5) und/oder den elektrischen Kontaktbereichen (6) auf dem Schaltungsträger (4) und dem elektrischen Kontaktbereich (11) eines *Folienleiterstreifens* (7) von außerhalb des Gehäusedeckels (12) durch mindestens eine Aussparung (18) im Gehäusedeckel (12), und
f) Montage eines mittels Laserschweißen oder Kleben oder Verstemmen mit dem Gehäusedeckel (12) koppelbaren, die Aussparung (18) öldicht abschließenden Deckelteils (19).

## Claims

1. Control device for a motor vehicle, which comprises:
a) a base plate (1),
b) a circuit carrier (4) which is arranged on the base plate (1) and which comprises at least one electronic component (5) and/or at least one electrical contact region (6),
c) a frame (3) which circumferentially surrounds the circuit carrier (4) and is coupled in an oil-tight manner to the base plate (1) by means of a seal (2) which circumferentially surrounds the circuit carrier (4),
d) at least one foil conductor (7), which runs on the base plate (1), for electrically connecting electronic components within the frame (3) to electronic components outside the frame (3), and
e) electrical connecting lines (8) between the components (5) and/or the contact regions (6) on the circuit carrier (4) and the foil conductor (7),
f) a housing cover (12) which is coupled in an oil-tight manner to the frame (3),
**characterized in that**
g) the foil conductors (7) are designed as a plurality of separate foil conductor strips which each have an electrical contact region (11) at their end sections (10) which face the circuit carrier (4), wherein the end sections (10) are arranged outside the seal (2) which circumferentially surrounds the circuit carrier (4),
h) the frame (3), in the region of the electrical contact region (11) of a foil conductor strip (7), has an aperture (9) for conducting through the electrical connecting lines (8) from the components (5) and/or the contact regions (6) on the circuit carrier (4) to the electrical contact region (11) of the foil conductor strip (7), and
i) the frame (3) has a seal (13) which runs around the aperture (9) and surrounds the electrical contact region (11) of the foil conductor strip (7) and by means of which the frame (3), in the region of the aperture (9), is coupled in an oil-tight manner to the foil conductor strip on the base plate (1).

2. Control device according to Claim 1, **characterized in that** the seal (13) which runs around the aperture (9) is arranged entirely within the foil conductor strip (7).

3. Control device according to Claim 1 or 2, **characterized in that** the base plate (1) has a recess for receiving the frame (3) .

4. Control device according to one of the preceding claims, **characterized in that** the seal (2) which runs around the circuit carrier (4) and the seal (13) which runs around an aperture (9) are formed from one piece, wherein the respective sealing faces (14, 15) are separated by a groove (17) in the region of apertures (9) in which they run in an adjoining manner virtually in parallel.

5. Control device according to one of the preceding claims, **characterized in that** the frame (3) is integrated on the housing cover (12).

6. Control device according to Claim 5, **characterized in that** the housing cover (12), in each case in the region which comprises an electronic component (5) and/or an electrical contact region (6) on the circuit carrier (4) and an electrical contact region (11) of the corresponding end section (10) of the foil conductor strip (7), has a cutout (18) through which an electrical connection between the electronic component (5) and/or the contact region (6) of the circuit carrier (4) and the electrical contact region (11) of the corresponding end section (10) of the foil conductor strip (7) can be established by means of the electrical connecting lines (8), wherein the cutout (18) can be closed in an oil-tight manner by a cover part (19).

7. Control device according to Claim 6, **characterized in that** the cutout (18) is closed in an oil-tight manner by the cover part (19) by means of laser welding or adhesive bonding or caulking.

8. Control device according to one of the preceding claims, **characterized in that** the base plate (1) is part of a transmission hydraulics unit.

9. Method for producing a control device for a motor vehicle according to Claim 1, **characterized by** the steps of:
a) providing a base plate (1),
b) fitting a circuit carrier (4) on the base plate (1), wherein the circuit carrier (4) comprises at least one electronic component (5) and/or at least one electrical contact region (6),
c) positioning and fixing a plurality of substantially strip-like foil conductors (7) on the base plate (1) in such a way that the end sections (10) of the foil conductor strips (7), which end sections face the circuit carrier (4) and are provided with an electrical contact region (11), are fixed in the region of at least one electronic component (5) and/or electrical contact region (6) of the circuit carrier (4),
d) mounting a frame (3), which circumferentially surrounds the circuit carrier (4), in such a way that an aperture (9) of the frame (3) is arranged above the electrical contact region (11) at the end section (10) of a foil conductor strip (7), wherein the frame (3) is coupled in an oil-tight manner to the base plate (1)
- in the immediate region of the circuit carrier (4) by means of a seal (2) which runs around the circuit carrier (4) and runs between the circuit carrier (4) and the end sections (10) of the foil conductors (7), and
- in the region of the aperture (9) by means of a seal (13) which runs around the aperture (9), surrounds the electrical contact region (11) of a foil conductor strip (7) and is arranged within the foil conductor (7),
e) fitting electrical connecting lines (8) between the electronic components (5) and/or the electrical contact regions (6) on the circuit carrier (4) and the electrical contact region of the foil conductor strip (11) through the corresponding aperture (9), and
f) mounting a housing cover (12), which can be coupled in an oil-tight manner to the frame (3), over a seal (16).

10. Method for producing a control device for a motor vehicle according to Claim 5, **characterized by** the steps of:
a) providing a base plate (1),
b) fitting a circuit carrier (4) on the base plate (1), wherein the circuit carrier (4) comprises at least one electronic component (5) and/or at least one electrical contact region (6),
c) positioning and fixing a plurality of substantially strip-like foil conductors (7) on the base plate (1) in such a way that the end sections (10) of the foil conductor strips (7), which end sections face the circuit carrier (4) and are provided with an electrical contact region (11), are fixed in the region of at least one electronic component (5) and/or electrical contact region (6) of the circuit carrier (4),
d) mounting a substantially hood-like housing cover (12) having an edge (20), which runs in the interior of the cover and circumferentially surrounds the circuit carrier (4), in such a way that an aperture (9) of the edge (20) is arranged above an electrical contact region (11) at the end section (10) of a foil conductor strip (7), wherein the edge (20) is coupled in an oil-tight manner to the base plate (1)
- in the immediate region of the circuit carrier (4) by means of a seal (2) which runs around the circuit carrier (4) and runs between the circuit carrier (4) and the end sections (10) of the foil conductors (7), and
- in the region of the aperture (9) by means of a seal (13) which runs around the aperture (9), surrounds the electrical contact region (11) of a foil conductor (7) and is arranged within the foil conductor (7),
e) fitting electrical connecting lines (8) between the electronic components (5) and/or the electrical contact regions (6) on the circuit carrier (4) and the electrical contact region (11) of a foil conductor strip (7) from outside the housing cover (12) through at least one cutout (18) in the housing cover (12), and
f) mounting a cover part (19) which can be coupled to the housing cover (12) by means of laser welding or adhesive bonding or caulking and closes off the cutout (18) in an oil-tight manner.

## Revendications

1. Contrôleur pour un véhicule automobile, comprenant :
a) une plaque de fond (1),
b) un porte-circuit (4) qui est disposé sur la plaque de fond (1) et qui comporte au moins un composant électronique (5) et/ou au moins une zone de contact (6) électrique,
c) un cadre (3) qui entoure le porte-circuit (4) sur sa périphérie, lequel est accouplé de manière étanche à l'huile (2) avec la plaque de fond (1) au moyen d'une garniture d'étanchéité qui entoure le porte-circuit (4) sur sa périphérie,
d) au moins un conducteur plat flexible (7) qui s'étend sur la plaque de fond (1), destiné à relier électriquement des composants électroniques à l'intérieur du cadre (3) avec des composants électroniques à l'extérieur du cadre (3), et
e) des lignes de liaison (8) électriques entre les composants (5) et/ou les zones de contact (6) sur le porte-circuit (4) et le conducteur plat flexible (7),
f) un couvercle de boîtier (12) qui est accouplé de manière étanche à l'huile avec le cadre (3),
**caractérisé en ce que**
g) les conducteurs plats flexibles (7) sont réalisés sous la forme de plusieurs bandes conductrices plates flexibles séparées qui possèdent respectivement une zone de contact (11) électrique au niveau de leurs portions d'extrémité (10) faisant face au porte-circuit (4), les portions d'extrémité (10) étant disposées en-dehors de la garniture d'étanchéité (2) qui entoure le porte-circuit (4) sur sa périphérie,
h) le cadre (3) possède, dans la zone de la zone de contact (11) électrique d'une bande conductrice plate flexible (7), une percée (9) servant à la traversée des lignes de liaison (8) électriques depuis les composants (5) et/ou les zones de contact (6) sur le porte-circuit (4) vers la zone de contact (11) électrique de la bande conductrice plate flexible (7), et
i) le cadre (3) possède une garniture d'étanchéité (13) qui entoure la zone de contact (11) électrique de la bande conductrice plate flexible (7) de manière périphérique autour de la percée (9), au moyen de laquelle le cadre (3) est couplé de manière étanche à l'huile aux bandes conductrices plates flexibles sur la plaque de fond (1) dans la zone de la percée (9) .

2. Contrôleur selon la revendication 1, **caractérisé en ce que** la garniture d'étanchéité (13) qui entoure la percée (9) est disposée entièrement à l'intérieur de la bande conductrice plate flexible (7).

3. Contrôleur selon la revendication 1 ou 2, **caractérisé en ce que** la plaque de fond (1) possède un renfoncement destiné à accueillir le cadre (3).

4. Contrôleur selon l'une des revendications précédentes, **caractérisé en ce que** la garniture d'étanchéité (2) qui entoure le porte-circuit (4) et la garniture d'étanchéité (13) qui entoure ladite percée (9) sont réalisées d'un seul tenant, les surfaces d'étanchéité (14, 15) respectives dans la zone des percées (9), dans laquelle elles s'étendent pratiquement en parallèle en étant adjacentes, sont séparées par une rainure (17) .

5. Contrôleur selon l'une des revendications précédentes, **caractérisé en ce que** le cadre (3) est intégré sur le couvercle de boîtier (12).

6. Contrôleur selon la revendication 5, **caractérisé en ce que** le couvercle de boîtier (12) possède, respectivement dans la zone qui comporte un composant électronique (5) et/ou une zone de contact (6) électrique sur le porte-circuit (4) et une zone de contact (11) électrique de la portion d'extrémité (10) correspondante de la bande conductrice plate flexible (7), une cavité (18) à travers laquelle peut être établie une liaison électrique entre le composant électronique (5) et/ou la zone de contact (6) du porte-circuit (4) et la zone de contact (11) électrique de la portion d'extrémité (10) correspondante de la bande conductrice plate flexible (7) au moyen des lignes de liaison (8) électriques, la cavité (18) pouvant être fermée de manière étanche à l'huile avec une partie de couvercle (19).

7. Contrôleur selon la revendication 6, **caractérisé en ce que** la cavité (18) est fermée avec la partie de couvercle (19) par soudage au laser ou par collage ou par matage.

8. Contrôleur selon l'une des revendications précédentes, **caractérisé en ce que** la plaque de fond (1) est une partie d'une unité hydraulique de boîte de vitesses.

9. Procédé de fabrication d'un contrôleur pour un véhicule automobile selon la revendication 1, **caractérisé par** les étapes suivantes :
a) fourniture d'une plaque de fond (1),
b) pose d'un porte-circuit (4) sur la plaque de fond (1), le porte-circuit (4) comportant au moins un composant électronique (5) et/ou au moins une zone de contact (6) électrique,
c) positionnement et fixation de plusieurs conducteurs plats flexibles (7), sensiblement en forme de bandes, sur la plaque de fond (1) de telle sorte que les portions d'extrémité (10) des bandes conductrices plates flexibles (7), qui font face au porte-circuit (4) et qui sont pourvues d'une zone de contact (11) électrique, sont fixées dans la zone d'au moins un composant électronique (5) et/ou d'une zone de contact (6) électrique du porte-circuit (4),
d) montage d'un cadre (3) qui entoure le porte-circuit (4) sur sa périphérie de telle sorte qu'une percée (9) du cadre (3) est disposée au-dessus de la zone de contact (11) électrique au niveau de la portion d'extrémité (10) d'une bande conductrice plate flexible (7), le cadre (3) étant accouplé de manière étanche à l'huile avec la plaque de fond (1)
- dans la zone directe du porte-circuit (4) au moyen d'une garniture d'étanchéité (2) périphérique autour du porte-circuit (4) et qui s'étend entre le porte-circuit (4) et les portions d'extrémité (10) du conducteur plat flexible (7), et
- dans la zone de la percée (9) au moyen d'une garniture d'étanchéité (13) périphérique autour de la percée (9) et qui entoure la zone de contact (11) électrique d'une bande conductrice plate flexible (7) et qui est disposée à l'intérieur du conducteur plat flexible (7),
e) application de lignes de liaison (8) électriques entre les composants électroniques (5) et/ou les zones de contact (6) électriques sur le porte-circuit (4) et la zone de contact électrique de la bande conductrice plate flexible (11) à travers la percée (9) correspondante, et
f) montage d'un couvercle de boîtier (12) qui peut être accouplé de manière étanche à l'huile avec le cadre (3) par le biais d'une garniture d'étanchéité (16).

10. Procédé de fabrication d'un contrôleur pour un véhicule automobile selon la revendication 5, **caractérisé par** les étapes suivantes :
a) fourniture d'une plaque de fond (1),
b) pose d'un porte-circuit (4) sur la plaque de fond (1), le porte-circuit (4) comportant au moins un composant électronique (5) et/ou au moins une zone de contact (6) électrique,
c) positionnement et fixation de plusieurs conducteurs plats flexibles (7), sensiblement en forme de bandes, sur la plaque de fond (1) de telle sorte que les portions d'extrémité (10) des bandes conductrices plates flexibles (7), qui font face au porte-circuit (4) et qui sont pourvues d'une zone de contact (11) électrique, sont fixées dans la zone d'au moins un composant électronique (5) et/ou d'une zone de contact (6) électrique du porte-circuit (4),
d) montage d'un couvercle de boîtier (12) sensiblement en forme de capot, comprenant un bord (20) qui s'étend à l'intérieur du couvercle et qui entoure le porte-circuit (4) sur sa périphérie de telle sorte qu'une percée (9) du bord (20) est disposée au-dessus de la zone de contact (11) électrique au niveau de la portion d'extrémité (10) d'une bande conductrice plate flexible (7), le bord (20) étant accouplé de manière étanche à l'huile avec la plaque de fond (1)
- dans la zone directe du porte-circuit (4) au moyen d'une garniture d'étanchéité (2) périphérique autour du porte-circuit (4) et qui s'étend entre le porte-circuit (4) et les portions d'extrémité (10) du conducteur plat flexible (7), et
- dans la zone de la percée (9) au moyen d'une garniture d'étanchéité (13) périphérique autour de la percée (9) et qui entoure la zone de contact (11) électrique d'un conducteur plat flexible (7) et qui est disposée à l'intérieur du conducteur plat flexible (7),
e) application de lignes de liaison (8) électriques entre les composants électroniques (5) et/ou les zones de contact (6) électriques sur le porte-circuit (4) et la zone de contact électrique (11) d'une bande conductrice plate flexible (7) depuis l'extérieur du couvercle de boîtier (12) à travers au moins une cavité (18) dans le couvercle de boîtier (12), et
f) montage d'une partie de couvercle (19) qui peut être accouplée au couvercle de boîtier (12) par soudure au laser, collage, ou matage, et qui ferme la cavité (18) de manière étanche à l'huile.
